# EUROPEAN PATENT APPLICATION

(11) **EP 4 543 183 A1**
(43) Date of publication of application: **23.04.2025**
(21) Application number: 23852496.1
(22) Date of filing: 04.08.2023
(51) Int. Cl.: H10N 10/17, H02N 11/00, H10N 10/13, H10N 10/817

(54) **THERMOELECTRIC GENERATION MODULE AND THERMOELECTRIC GENERATION UNIT**

(30) Priority: 12.08.2022 JP 2022129049; 12.08.2022 JP 2022129050
(71) Applicant: KELK Ltd., Kanagawa 254-8543 (JP)
(72) Inventor: OBA, Masakazu, Hiratsuka-shi, Kanagawa 254-8543 (JP); KISHIZAWA, Toshihiko, Hiratsuka-shi, Kanagawa 254-8543 (JP)
(74) Representative: Flügel Preissner Schober Seidel
(86) International application number: PCT/JP2023/028532
(87) International publication number: WO 2024/034531

(57) **Abstract**

A thermoelectric power generation module 10 including: a first base material 11 formed in a sheet shape; a second base material 12 formed in a sheet shape; a plurality of thermoelectric conversion elements 21 disposed between the first base material 11 and the second base material 12; a plurality of first electrodes 22 disposed between the first base material 11 and the thermoelectric conversion elements 21; a plurality of second electrodes 23 disposed between the second base material 12 and the thermoelectric conversion elements 21; and a joint part A that joins the first base material 11 and the second base material 12, in which the thermoelectric conversion elements 21, the plurality of first electrodes 22, and the plurality of second electrodes 23 are sealed by the joint part **A,** and the joint part A bonds the first base material 11 and the second base material 12 with a metal film 13 and a metal film 14 interposed therebetween by soldering.

## Description

### Field

The present disclosure relates to a thermoelectric power generation module and a thermoelectric power generation unit.

### Background

Thermoelectric power generation modules are for use in factories and facilities that perform incineration and heat treatment, and therefore operate under environments exposed to wind and rain, high humidity and high temperature environments, and dust. Therefore, in a thermoelectric power generation module causing a potential difference, water and dust serve as an electric path, and a short circuit is likely to occur. The thermoelectric power generation module accordingly has an outer peripheral part sealed so that water and dust do not enter the inside. In addition, the thermoelectric power generation module is repeatedly raised and lowered in temperature from room temperature to about 300°C. Therefore, a sealing structure of the thermoelectric power generation module is required to have heat resistance and temperature resistance cyclicity.

There is known a technique including a plurality of thermoelectric elements, an outer sealing frame surrounding a periphery of the thermoelectric elements, a thin film sheet continuously covering the thermoelectric elements and the outer sealing frame, and an inner sealing frame surrounding a periphery of a fastening means (see, **e.g.,** Patent Literature 1).

### Citation List

### Patent Literature

Patent Literature 1: Japanese Patent No. 6405130 Summary

### Technical Problem

In the technique described in Patent Literature 1, since the thin film sheet and the sealing frame, which are different kinds of materials, are solder-bonded, there is a possibility that deformation or warpage occurs due to a difference in thermal expansion coefficient of the materials. Accordingly, there is a possibility that a sealing property is lowered, and there is a possibility that a thermoelectric power generation module is disconnected. In addition, since the outer sealing frame is close to a heat receiving plate and a cooling plate, heat may leak along the outer sealing frame. As a result, there is a possibility that power generation output of the thermoelectric power generation module is lowered.

An object of the present disclosure is to suppress a decrease in sealing property, to reduce a possibility of disconnection, and to suppress a decrease in power generation output.

### Solution to Problem

According to an aspect of the present invention, a thermoelectric power generation module comprises: a first base material formed in a sheet shape; a second base material formed in a sheet shape; a plurality of thermoelectric conversion elements disposed between the first base material and the second base material; a plurality of first electrodes disposed between the first base material and the thermoelectric conversion elements; a plurality of second electrodes disposed between the second base material and the thermoelectric conversion elements; and a joint part that joins the first base material and the second base material, wherein the thermoelectric conversion elements, the plurality of first electrodes, and the plurality of second electrodes are sealed by a joint part, and the joint part bonds the first base material and the second base material with a metal film interposed therebetween by soldering.

According to another aspect of the present invention, a thermoelectric power generation module comprises: a first base material formed in a sheet shape; a second base material formed in a sheet shape; a plurality of thermoelectric conversion elements disposed between the first base material and the second base material; a plurality of first electrodes disposed between the first base material and the thermoelectric conversion elements; a plurality of second electrodes disposed between the second base material and the thermoelectric conversion elements; and a joint part that joins the first base material and the second base material, wherein the thermoelectric conversion elements, the plurality of first electrodes, and the plurality of second electrodes are sealed by a joint part, and the joint part joins the first base material and the second base material in a state where at least one of the first and second base materials is bent. According to this, a joined area and a thickness of the joint part can be increased as compared with a state in which the first base material and the second base material are joined without being bent.

According to still another aspect of the present invention, a thermoelectric power generation unit comprises: the thermoelectric power generation module; a heat receiving plate disposed on the first base material side of the thermoelectric power generation module; a first heat transfer member interposed between the thermoelectric power generation module and the heat receiving plate; a cooling plate disposed on the second base material side of the thermoelectric power generation module; and a second heat transfer member interposed between the thermoelectric power generation module and the cooling plate. Advantageous Effects of Invention

According to the present disclosure, it is possible to suppress a decrease in sealing property, to reduce a possibility of disconnection, and to suppress a decrease in power generation output.

### Brief Description of Drawings

FIG. 1 is a cross-sectional view schematically illustrating a thermoelectric power generation unit according to a first embodiment.
FIG. 2 is a cross-sectional view schematically illustrating a thermoelectric power generation module according to the first embodiment.
FIG. 3 is a partially enlarged view of a joint part of the thermoelectric power generation module in FIG. **2****.**
FIG. 4 is a plan view schematically illustrating a first base material of the thermoelectric power generation module according to the first embodiment and is a view as viewed from above.
FIG. 5 is a partially enlarged view of a joint part of a thermoelectric power generation module according to Modification 1 of the first embodiment.
FIG. 6 is a partially enlarged view of a joint part of a thermoelectric power generation module according to Modification 2 of the first embodiment.
FIG. 7 is a partially enlarged view of a joint part of a thermoelectric power generation module according to Modification 3 of the first embodiment.
FIG. 8 is a partially enlarged view of a joint part of a thermoelectric power generation module according to Modification 4 of the first embodiment.
FIG. 9 is a partially enlarged view of a joint part of a thermoelectric power generation module according to Modification 5 of the first embodiment.
FIG. 10 is a cross-sectional view schematically illustrating a thermoelectric power generation module according to Modification 6 of the first embodiment.
FIG. 11 is a cross-sectional view schematically illustrating a thermoelectric power generation unit according to Modification 7 of the first embodiment.
FIG. 12 is a cross-sectional view schematically illustrating a thermoelectric power generation unit according to Modification 8 of the first embodiment.
FIG. 13 is a cross-sectional view schematically illustrating a thermoelectric power generation unit according to Modification 9 of the first embodiment.
FIG. 14 is a cross-sectional view schematically illustrating a thermoelectric power generation unit according to a second embodiment.
FIG. 15 is a cross-sectional view schematically illustrating a thermoelectric power generation module according to the second embodiment.
FIG. 16 is a partially enlarged view of a joint part of the thermoelectric power generation module in FIG. 15.
FIG. 17 is a partially enlarged view of a joint part of a thermoelectric power generation module according to Modification 1 of the second embodiment.
FIG. 18 is a partially enlarged view of a joint part of a thermoelectric power generation module according to Modification 2 of the second embodiment.
FIG. 19 is a partially enlarged view of a joint part of a thermoelectric power generation module according to Modification 3 of the second embodiment.
FIG. 20 is a cross-sectional view schematically illustrating a thermoelectric power generation module according to Modification 4 of the second embodiment.
FIG. 21 is a cross-sectional view schematically illustrating a thermoelectric power generation unit according to Modification 5 of the second embodiment.
FIG. 22 is a cross-sectional view schematically illustrating a thermoelectric power generation unit according to Modification 6 of the second embodiment.
FIG. 23 is a cross-sectional view schematically illustrating a thermoelectric power generation unit according to Modification 7 of the second embodiment. Description of Embodiments

Although embodiments according to the present disclosure will be described with reference to the drawings in the following, the present disclosure is not limited thereto. Components of the plurality of embodiments described below can be appropriately combined. In addition, some components may not be used.

In the embodiment, a positional relationship of each part will be described using terms of "left", "right", "front", "rear", **"up",** and "down". These terms indicate a relative position or direction with respect to the center of a thermoelectric power generation unit 1. A left-right direction, a front-rear direction, and an up-down direction are orthogonal to each other.

### (First Embodiment)

### [Thermoelectric Power Generation Unit]

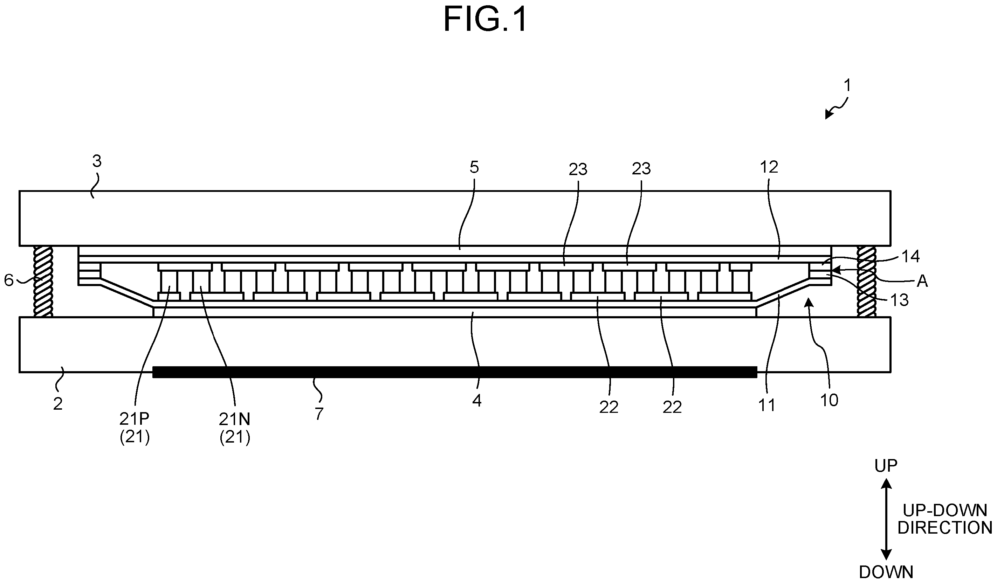

FIG. 1 is a cross-sectional view schematically illustrating a thermoelectric power generation unit according to a first embodiment. A thermoelectric power generation unit 1 includes a thermoelectric power generation module 10, a heat receiving plate 2 that is a high-temperature plate, a cooling plate 3 that is a low-temperature plate, a first heat transfer member 4, and a second heat transfer member 5.

The heat receiving plate 2 is disposed on a first base material 11 side of the thermoelectric power generation module 10. The heat receiving plate 2 receives heat from a heat source and transfers the heat to the thermoelectric power generation module 10 with a small in-plane temperature distribution. The heat receiving plate 2 is made of a metal material having high thermal conductivity, such as copper or aluminum.

The heat receiving plate 2 is in surface contact with the first heat transfer member 4 located on a lower surface side of a first electrode 22 disposed on the first base material 11. The heat receiving plate 2 is a rectangular plate-shaped member. The heat receiving plate 2 is formed of a material having high thermal conductivity. The heat receiving plate 2 is installed in a facility serving as a heat source. The heat receiving plate 2 receives heat from the facility serving as a heat source. Heat of the heat receiving plate 2 is conducted to the thermoelectric power generation module 10 through a heat transfer member (not illustrated).

The heat receiving plate 2 may be subjected to surface treatment on a surface opposite to a surface opposed to the first base material 11 of the thermoelectric power generation module 10, in other words, on a heat receiving surface which is a surface on the heat source side. The heat receiving surface may be surface-treated so that a radiation factor (i.e., emissivity) is different between a peripheral edge part and a central part. In the embodiment, the heat receiving surface is surface-treated so that the radiation factor at the central part is higher than that at the peripheral edge part. In FIG. 1, a surface-treated part subjected to the surface treatment is schematically indicated by reference numeral 7.

The cooling plate 3 is disposed on a second base material 12 side of the thermoelectric power generation module 10. The cooling plate 3 cools one side of the thermoelectric power generation module 10 and efficiently generates power while maintaining a temperature difference. The cooling plate 3 is made of a metal material having high thermal conductivity, such as copper or aluminum.

The cooling plate 3 is in surface contact with the second heat transfer member 5 located on an upper surface side of a second electrode 23 disposed on the second base material 12. The cooling plate 3 is opposed to the heat receiving plate 2 in the up-down direction and is installed to be separated from the heat receiving plate 2. The cooling plate 3 is a rectangular plate-shaped member. The cooling plate 3 is formed of a material having high thermal conductivity. The cooling plate 3 receives heat from the thermoelectric power generation module 10. Heat of the cooling plate 3 is radiated to a periphery of the thermoelectric power generation unit 1 or is cooled with water.

The first heat transfer member 4 is interposed between the thermoelectric power generation module 10 and the heat receiving plate 2. The first heat transfer member 4 fills an air layer between the thermoelectric power generation module 10 and the heat receiving plate 2 to reduce contact thermal resistance and improve heat transfer. The first heat transfer member 4 is formed in a sheet shape using, for example, carbon, silicon, or the like.

The second heat transfer member 5 is interposed between the thermoelectric power generation module 10 and the cooling plate 3. The second heat transfer member 5 fills an air layer between the thermoelectric power generation module 10 and the cooling plate 3 to reduce contact thermal resistance and improve heat transfer. The second heat transfer member 5 is formed in a sheet shape using, for example, carbon, silicon, or the like.

The first heat transfer member 4 and the second heat transfer member 5 are not limited to sheet-shaped members. The first heat transfer member 4 and the second heat transfer member 5 may be, for example, heat transfer grease.

The thermoelectric power generation unit 1 is fastened by a fastening member 6 while the thermoelectric power generation module 10 is sandwiched in the up-down direction between the heat receiving plate 2 and the cooling plate **3.**

### [Thermoelectric Power Generation Module]

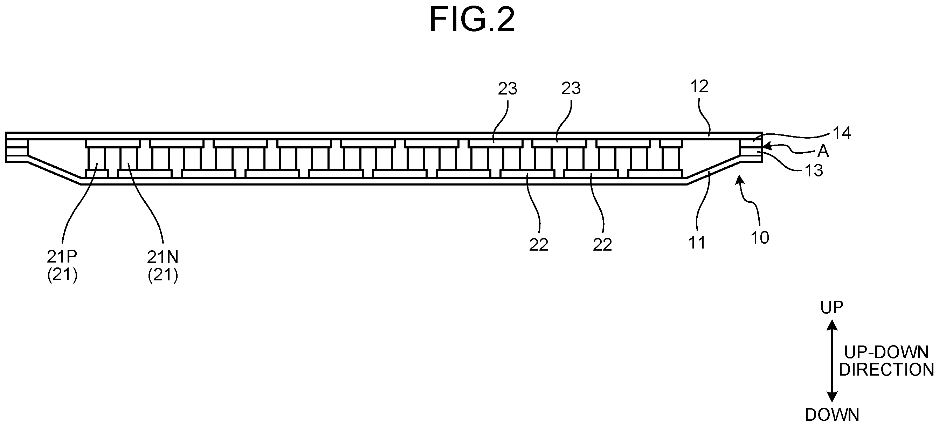

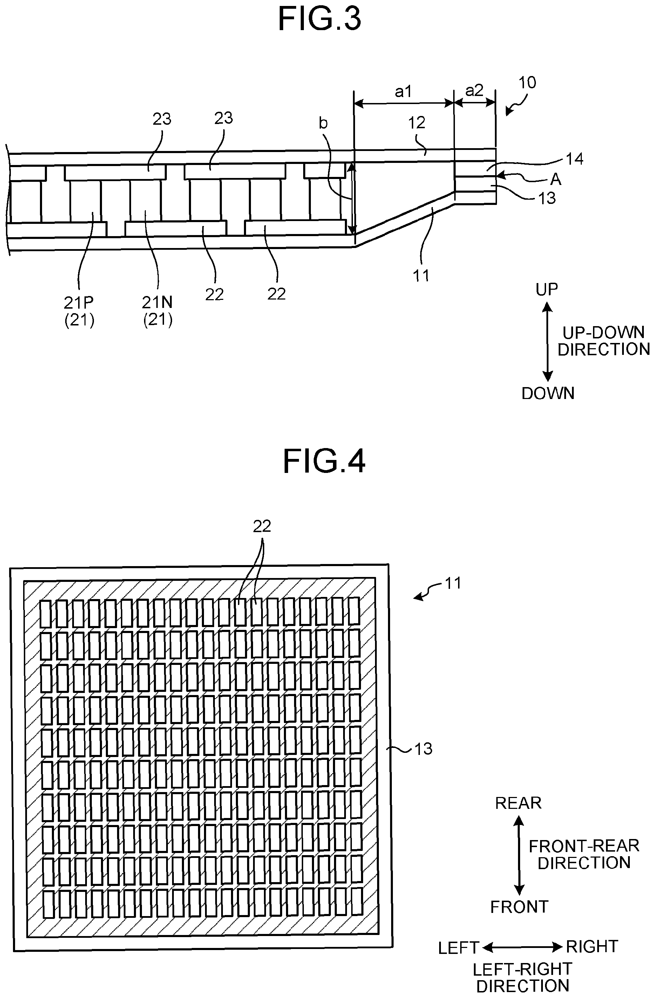

FIG. 2 is a cross-sectional view schematically illustrating the thermoelectric power generation module according to the first embodiment. FIG. 3 is a partially enlarged view of a joint part of the thermoelectric power generation module in FIG. 2. FIG. 4 is a plan view schematically illustrating the first base material of the thermoelectric power generation module according to the first embodiment and is a view as viewed from above. The thermoelectric power generation module 10 is installed between the heat receiving plate 2 and the cooling plate 3. The thermoelectric power generation module 10 generates electric power by the Seebeck effect by applying a temperature difference to its opposite sides (upper and lower sides in the drawing) by the heat receiving plate 2 and the cooling plate 3.

As illustrated in FIGS. 2 and 3, the thermoelectric power generation module 10 includes the first base material 11, the second base material 12, and a thermoelectric conversion element 21 disposed between the first base material 11 and the second base material 12. Arrangement of the thermoelectric conversion element 21, the first electrode 22, and the second electrode 23 in each drawing used in the following description is schematically illustrated.

Each of the first base material 11 and the second base material 12 is formed of an electrically insulating material. As illustrated in FIG. 4, the first base material 11 is made of, for example, sheet-shaped polyimide. Although not illustrated, the second base material 12 is made of, for example, sheet-shaped polyimide, similarly to the first base material 11. Each of the first base material 11 and the second base material 12 has flexibility. In the embodiment, the first base material 11 and the second base material 12 are formed in a rectangular shape. The first base material 11 and the second base material 12 are opposed to each other with the thermoelectric conversion element 21 interposed therebetween. In the embodiment, the second base material 12 is disposed above the first base material 11.

In the embodiment, the first base material 11 and the first heat transfer member 4 are not joined to each other, and the second base material 12 and the second heat transfer member 5 are not joined to each other.

In the embodiment, the first base material 11 has a peripheral edge part bent toward the second base material 12, in other words, bent so as to approach the second base material 12.

A metal film 13 and a metal film 14 are regions where the first base material 11 and the second base material 12 are joined. The metal film 13 and the metal film 14 are metal thin films disposed in a frame shape. The metal film 13 and the metal film 14 are disposed to surround a periphery of a plurality of pn element pairs aligned in a plane direction as viewed in the up-down direction. The metal film 13 is disposed on a peripheral edge part of an upper surface of the first base material 11. The metal film 14 is disposed on a peripheral edge part of a lower surface of the second base material 12.

In a state in which thus configured first base material 11 and second base material 12 are overlapped with each other, the peripheral edge part of the upper surface of the first base material 11 and the peripheral edge part of the lower surface of the second base material 12 are bonded with solder or a resin adhesive and sealed via the metal film 13 and the metal film 14.

A part where the first base material 11 and the second base material 12 are joined is referred to as a joint part A. In the embodiment, a part where the metal film 13 and the metal film 14 are joined is referred to as the joint part A. The joint part A is disposed in the peripheral edge parts of the first base material 11 and the second base material 12. In the first base material 11 and the second base material 12 having rectangular shapes, four sides are the joint parts A.

In the joint part A, the metal films 13 and 14 of the first base material 11 and the second base material 12 are bonded to each other by solder or a resin adhesive. Examples of a material of the solder include Pb-Sn, Sn-Ag-Cu, Cu-Sn, Sn-Sb, Bi-Sn, Au-Sn, and Zn-Sn. The resin adhesive is formed of a resin material having high heat resistance that can withstand a use environment of the thermoelectric power generation unit 1.

In the embodiment, the joint part A is separated from the heat receiving plate 2 and is located on the cooling plate 3 side.

A dimension of a peripheral edge part of the thermoelectric power generation module 10, specifically, dimensions of the joint part A and a peripheral part thereof may be as follows. As illustrated in FIG. 3, a length from an outer edge part of a plurality of the first electrodes 22 and a plurality of the second electrodes 23 disposed between the first base material 11 and the second base material 12 to the joint part A is defined as a1. A length of the joint part A is defined as a2. A length between the upper surface side of the first base material 11 and the lower surface side of the second base material 12 is defined as b. At this time, a1, a2, and b may be set such that a1+a2>b holds.

One or more thermoelectric conversion elements 21 are disposed between the upper surface side of the first base material 11 and the lower surface side of the second base material 12. The plurality of thermoelectric conversion elements 21 is connected by the plurality of first electrodes 22 and the plurality of second electrodes 23.

The thermoelectric conversion element 21 is formed of a thermoelectric material. Examples of the thermoelectric material for forming the thermoelectric conversion element 21 include a manganese silicide-based compound (Mn-Si), a magnesium silicide-based compound (Mg-Si-Sn), a skutterudite-based compound (Co-Sb), a half-heusler-based compound (Zr-Ni-Sn), and a bismuth tellurium compound (Bi-Te). The thermoelectric conversion element 21 may be made of one compound selected from a manganese silicide-based compound, a magnesium silicide-based compound, a skutterudite-based compound, a half-heusler compound, and a bismuth tellurium compound, or may be made of a combination of at least two of the compounds.

The thermoelectric conversion element 21 includes a p-type element 21P and an n-type element 21N. A plurality of the p-type elements 21P and a plurality of the n-type elements 21N are arranged in a predetermined plane. The p-type elements 21P and the n-type elements 21N are alternately arranged in the front-rear direction. In the left-right direction, the p-type elements 21P and the n-type elements 21N are alternately arranged.

The first electrode 22 and the second electrode 23 are formed of a conductive metal. The first electrode 22 is disposed between the first base material 11 and the thermoelectric conversion element 21. The first electrode 22 is provided on the upper surface of the first base material 11. A plurality of the first electrodes 22 is provided in a predetermined plane parallel to the upper surface of the first base material 11. The second electrode 23 is disposed between the second base material 12 and the thermoelectric conversion element 21. The second electrode 23 is provided on the lower surface of the second base material 12. A plurality of the second electrodes 23 is provided in a predetermined plane parallel to the lower surface of the second base material 12.

The first electrode 22 and the second electrode 23 are each connected to a pair of adjacent p-type element 21P and n-type element 21N. The first electrodes 22 and the second electrodes 23 connect the plurality of thermoelectric conversion elements 21 in series. The first electrodes 22 and the second electrodes 23 form a series circuit in which the plurality of thermoelectric conversion elements 21 is connected in series. The p-type element 21P and the n-type element 21N are electrically connected via the first electrode 22 and the second electrode 23 to form the pn element pair. The series circuit including the plurality of thermoelectric conversion elements 21 is configured by connecting a plurality of the pn element pairs in series via the first electrodes 22 and the second electrodes 23.

When a current is supplied to the thermoelectric conversion element 21, the thermoelectric power generation module 10 absorbs heat or generates heat by the Peltier effect. When a temperature difference is applied between the first base material 11 and the second base material 12, the thermoelectric power generation module 10 generates electric power by the Seebeck effect.

The lower surface of first electrode 22 disposed on the first base material 11 is a heating surface of the thermoelectric power generation module 10. The upper surface of the second electrode 23 disposed on the second base material 12 is a cooling surface of the thermoelectric power generation module 10.

Electric power of the circuit is extracted from the thermoelectric power generation module 10 configured as described above to the outside via an end electrode and a lead wire (not illustrated).

An inside of thus sealed thermoelectric power generation module 10 is preferably degassed to a negative pressure or filled with, for example, an inert gas such as nitrogen and argon, or dry air. The inside of the sealed thermoelectric power generation module 10 may be filled with an inert liquid or varnish. Examples of the inert liquid include perfluoropolyether (PFPE), perfluorocarbon (PFC), and hydrofluoroether (HFE).

### [Sealing Method and Operation]

In a state where the first base material 11 and the second base material 12 are overlapped with each other, the joint part A which is the peripheral edge part thereof is bonded with solder or a resin adhesive. As a result, the first base material 11 and the second base material 12 are sealed at the joint part A which is the peripheral edge part.

### [Effects]

In the embodiment, the joint part A bonds the first base material 11 and the second base material 12 with solder or a resin adhesive via the metal film 13 and the metal film 14. In the embodiment, since a sealing frame of a different kind of material is not used, thermal deformation, warpage, and the like due to a difference in thermal expansion coefficient do not occur, and durability can be maintained. According to the embodiment, it is possible to reduce a possibility of deterioration of a sealing property and a possibility of disconnection of the thermoelectric power generation module 10.

In the embodiment, as compared with a central part of the thermoelectric power generation module 10 in which the thermoelectric conversion elements 21 are disposed, the joint part A that is a sealed part of an outer peripheral part of the thermoelectric power generation module 10 has a smaller thickness in the up-down direction, and a gap is generated between the joint part A and the heat receiving plate **2.** According to the embodiment, the joint part A can be disposed away from the heat receiving plate **2.** Therefore, in the embodiment, heat leakage from the heat receiving plate 2 to the cooling plate 3 can be suppressed at the joint part **A.** According to the embodiment, a possibility of reduction in power generation output of the thermoelectric power generation module 10 can be reduced.

In the embodiment, the first base material 11 and the second base material 12 can be bonded with solder or a resin adhesive without using a sealing member such as a sealing material and a frame member made of an adhesive or a resin material. In the embodiment, deterioration of a sealing member due to aging does not occur. According to the embodiment, the sealing property can be maintained for a long period of time under an environment exposed to wind and rain, a high humidity and high temperature environment, and dust. As described above, in the embodiment, since neither an adhesive nor a resin material having a low heat-resistant is used, heat resistance and temperature resistance cyclicity can be improved.

In the embodiment, it is possible to restrict water and dust which cause a short circuit from entering the inside of the thermoelectric power generation module 10 over a long period of time under an environment exposed to wind and rain, a high humidity and high temperature environment, and dust. In the embodiment, thermoelectric power generation can be performed while insulation is maintained for a long period of time under a high-temperature environment. In this way, according to the embodiment, it is possible to suppress the occurrence of a failure due to intrusion of moisture and to stably generate power.

As described above, according to the embodiment, it is possible to suppress a decrease in sealing property, to reduce a possibility of disconnection, and to suppress a decrease in power generation output.

In the embodiment, for example, when the thermoelectric power generation module 10 is manufactured by integral reflow molding, flux tends to remain. According to the embodiment, since steam is easily removed by the remaining flux, bulging of an electrode surface can be suppressed.

In the embodiment, a1, a2, and b are set such that a1+a2>b folds, where a1 is the length from the outer edge part of the first electrode 22 and the second electrode 23 to the joint part A, a2 is the length of the joint part A, and b is the length between the upper surface side of the first base material 11 and the lower surface side of the second base material 12. According to the embodiment, it is possible to prevent the joint part A from lowering by its own weight and coming into contact with the first base material 11.

Modifications 1 to 9 of the first embodiment will be described below.

### (Modification 1)

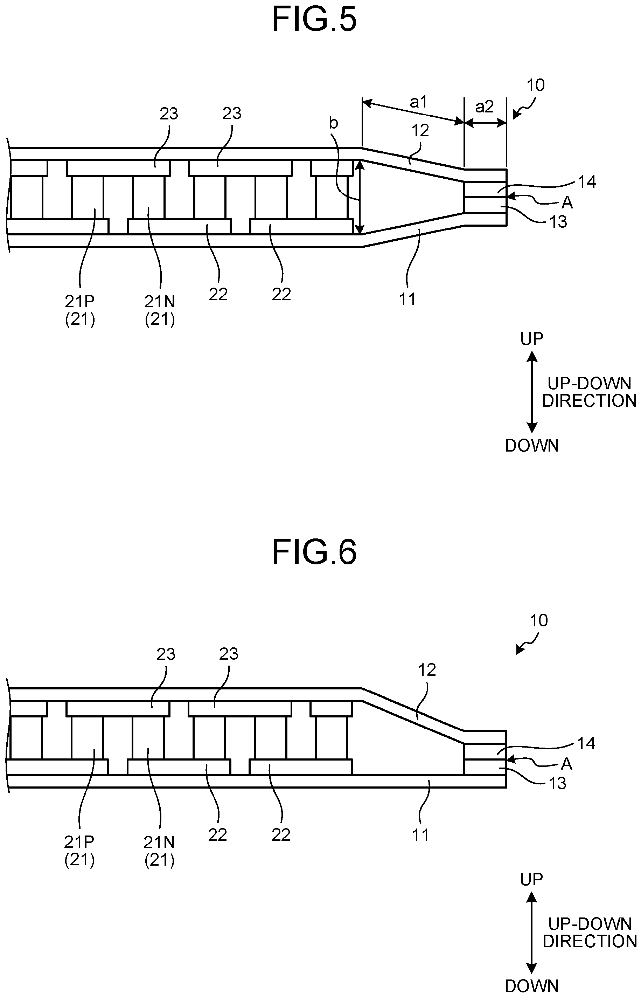

FIG. 5 is a partially enlarged view of a joint part of a thermoelectric power generation module according to Modification 1 of the first embodiment. Modification 1 is different from the first embodiment in a configuration of a joint part A.

In Modification 1, a part where a metal film 13 and a metal film 14 are joined is referred to as a joint part A. The joint part A is separated from a heat receiving plate 2 and a cooling plate 3. In other words, the joint part A is located at an intermediate part between the heat receiving plate 2 and the cooling plate 3 in the up-down direction (thickness direction).

A first base material 11 has a peripheral edge part bent toward a second base material 12, in other words, bent so as to approach the second base material 12. The second base material 12 has a peripheral edge part bent toward the first base material 11, in other words, bent so as to approach the first base material 11. The peripheral edge part of the first base material 11 and the peripheral edge part of the second base material 12 are formed so as to approach each other.

A length from an outer edge part of a plurality of first electrodes 22 and a plurality of second electrodes 23 disposed between the first base material 11 and the second base material 12 to the joint part A is defined as a1. A length of the joint part A is defined as a2. A length between the upper surface side of the first base material 11 and the lower surface side of the second base material 12 is defined as b. At this time, a1, a2, and b may be set such that a1+a2>b holds.

According to the modification, the joint part A can be disposed away from the heat receiving plate 2 and the cooling plate 3. In the modification, heat leakage from the heat receiving plate 2 to the cooling plate 3 can be suppressed at the joint part A.

In the modification, a1, a2, and b are set such that a1+a2>b holds, where a1 is the length from the outer edge part of the first electrodes 22 and the second electrodes 23 to the joint part A, a2 is the length of the joint part A, and b is the length between the upper surface side of the first base material 11 and the lower surface side of the second base material 12. According to the modification, it is possible to prevent the joint part A from lowering by its own weight and coming into contact with the first base material 11.

### (Modification 2)

FIG. 6 is a partially enlarged view of a joint part of a thermoelectric power generation module according to Modification 2 of the first embodiment. Modification 2 is different from the first embodiment in a configuration of a joint part A.

In Modification 2, a part where a metal film 13 and a metal film 14 are joined is referred to as a joint part A. The joint part A is separated from a cooling plate 3 and is located on a heat receiving plate 2 side.

The second base material 12 has a peripheral edge part bent toward the first base material 11, in other words, bent so as to approach the first base material 11.

According to the modification, the joint part A can be disposed away from the cooling plate 3. In the modification, heat leakage from the heat receiving plate 2 to the cooling plate 3 can be suppressed at the joint part A.

### (Modification 3)

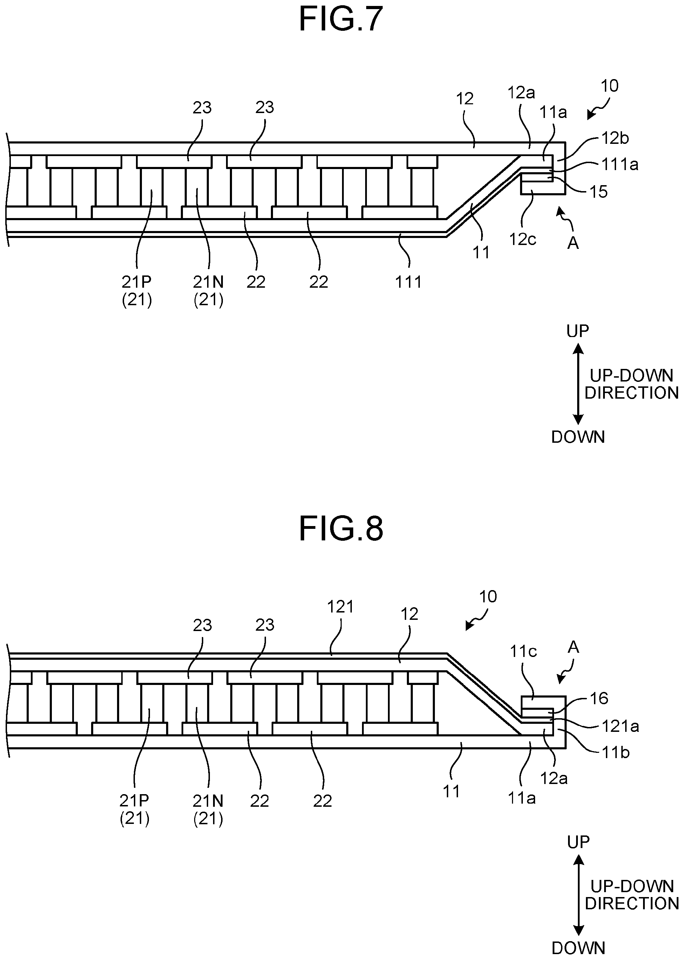

FIG. 7 is a partially enlarged view of a joint part of a thermoelectric power generation module according to Modification 3 of the first embodiment. Modification 3 is different from the first embodiment in a configuration of a joint part A.

In Modification 3, a part where a metal film 15 and a metal film 111 are joined is referred to as a joint part A. The joint part A is separated from a heat receiving plate 2 and is located on a cooling plate 3 side.

The metal film 111 is disposed on an entire lower surface of a first base material 11. A first base material 11 has a peripheral edge part bent toward a second base material 12, in other words, bent so as to approach the second base material 12. A distal end part 11a of the first base material 11 and a distal end part 111a of the metal film 111 are sandwiched by a distal end part 12a, a bent part 12b, and a distal end part 12c of the second base material 12.

The second base material 12 includes the metal film 15. The metal film 15 is configured similarly to the metal film 14 of the first embodiment. A peripheral edge part of the second base material 12 is folded back at the bent part 12b. The distal end part 12a and the distal end part 12c of the second base material 12 are separated in the up-down direction. The distal end part 11a of the first base material 11 and the distal end part 111a of the metal film 111 are sandwiched between the distal end part 12a and the distal end part 12c of the second base material 12. In other words, the distal end part 11a of the first base material 11 and the distal end part 111a of the metal film 111 are sandwiched by the distal end part 12a, the bent part 12b, and the distal end part 12c of the second base material 12.

In the joint part A, the distal end part 12c of the second base material 12, the metal film 15, the distal end part 111a of the metal film 111, the distal end part 11a of the first base material 11, and the distal end part 12a of the second base material 12 are joined in an overlapping state from below in the up-down direction. The distal end part 12a of the second base material 12 and the distal end part 11a of the first base material 11 are bonded with solder or a resin adhesive. The distal end part 111a of the metal film 111 and the metal film 15 are bonded with solder or a resin adhesive.

According to the modification, a joined area and a thickness of the joint part A can be increased as compared with a state in which the first base material 11 and the second base material 12 are joined without being bent. As a result, in the modification, the thickness of the joint part A can suppress warpage even in a case of a one-side heater.

According to the modification, the joint part A can be disposed away from the cooling plate 3. In the modification, heat leakage from the heat receiving plate 2 to the cooling plate 3 can be suppressed at the joint part A.

### (Modification 4)

FIG. 8 is a partially enlarged view of a joint part of a thermoelectric power generation module according to Modification 4 of the first embodiment. Modification 4 is different from the first embodiment in a configuration of a joint part A.

In Modification 4, a joint part A, which is a part where a metal film 16 and a metal film 121 are joined, is separated from a cooling plate 3 and is located on a heat receiving plate 2 side.

A first base material 11 includes the metal film 16. The metal film 16 is configured similarly to the metal film 13 of the first embodiment. A peripheral edge part of the first base material 11 is folded back at a bent part 11b. A distal end part 11a and a distal end part 11c of the first base material 11 are separated in the up-down direction. A distal end part 12a of a second base material 12 and a distal end part 121a of the metal film 121 are sandwiched between the distal end part 11a and the distal end part 11c of the first base material 11. In other words, the distal end part 12a of the second base material 12 and the distal end part 121a of the metal film 121 are sandwiched by the distal end part 11a, the bent part 11b, and the distal end part 11c of the first base material 11.

The second base material 12 has an upper surface, on whole of which the metal film 121 is disposed. The second base material 12 has a peripheral edge part bent toward the first base material 11, in other words, bent so as to approach the first base material 11. The distal end part 12a of the second base material 12 and the distal end part 121a of the metal film 121 are sandwiched by the distal end part 11a, the bent part 11b, and the distal end part 11c of the first base material 11.

In the joint part A, the distal end part 11a of the first base material 11, the distal end part 12a of the second base material 12, the distal end part 121a of the metal film 121, the metal film 16, and the distal end part 11c of the first base material 11 are joined in an overlapping state from below in the up-down direction. The distal end part 11a of the first base material 11 and the distal end part 12a of the second base material 12 are bonded with solder or a resin adhesive. The distal end part 121a of the metal film 121 and the metal film 16 are bonded with solder or a resin adhesive.

According to the modification, a joined area and a thickness of the joint part A can be increased as compared with a state in which the first base material 11 and the second base material 12 are joined without being bent. As a result, in the modification, the thickness of the joint part A can suppress warpage even in a case of a one-side heater.

According to the modification, the joint part A can be disposed away from the cooling plate 3. In the modification, heat leakage from the heat receiving plate 2 to the cooling plate 3 can be suppressed at the joint part A.

### (Modification 5)

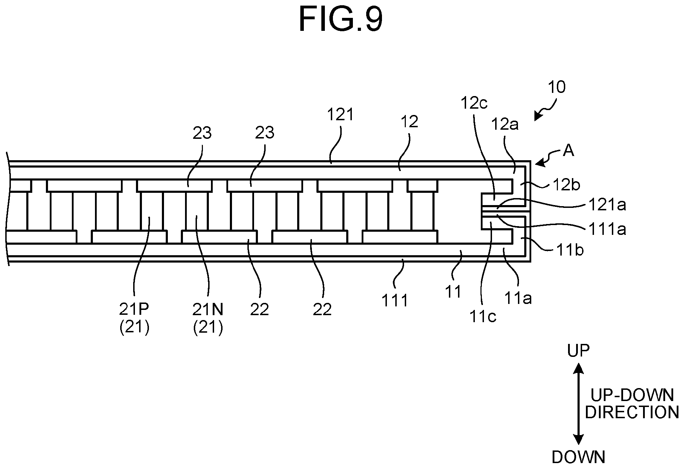

FIG. 9 is a partially enlarged view of a joint part of a thermoelectric power generation module according to Modification 5 of the first embodiment. Modification 5 is different from the first embodiment in a configuration of a joint part A.

The metal film 111 is disposed on an entire lower surface of a first base material 11. A peripheral edge part of the first base material 11 is folded back at a bent part 11b. A distal end part 11a and a distal end part 11c of the first base material 11 are separated in the up-down direction. A distal end part 111a of the metal film 111 disposed at the distal end part 11c of the first base material 11 is joined to a distal end part 121a of a metal film 121 disposed at a distal end part 12c of a second base material 12.

The second base material 12 has an upper surface, on whole of which the metal film 121 is disposed. A peripheral edge part of the second base material 12 is folded back at the bent part 12b. The distal end part 12a and the distal end part 12c of the second base material 12 are separated in the up-down direction. The distal end part 121a of the metal film 121 disposed at the distal end part 12c of the second base material 12 is joined to the distal end part 111a of the metal film 111 disposed at the distal end part 11c of the first base material 11.

In Modification 5, in a joint part in which the metal film 111 and the metal film 121 are joined, which is referred to as a joint part A, the metal film 111 disposed at the distal end part 11a of the first base material 11, the distal end part 11a of the first base material 11, the distal end part 11c of the first base material 11, the distal end part 111a of the metal film 111 disposed at the distal end part 11c of the first base material 11, the distal end part 121a of the metal film 121 disposed at the distal end part 12c of the second base material 12, the distal end part 12c of the second base material 12, the distal end part 12a of the second base material 12, and the metal film 121 disposed at the distal end part 12a of the second base material 12 are aligned from below in the up-down direction. The distal end part 111a of the metal film 111 disposed at the distal end part 11c of the first base material 11 and the distal end part 121a of the metal film 121 disposed at the distal end part 12c of the second base material 12 are bonded with solder or a resin adhesive.

According to the modification, a joined area and a thickness of the joint part A can be increased as compared with a state in which the first base material 11 and the second base material 12 are joined without being bent.

### (Modification 6)

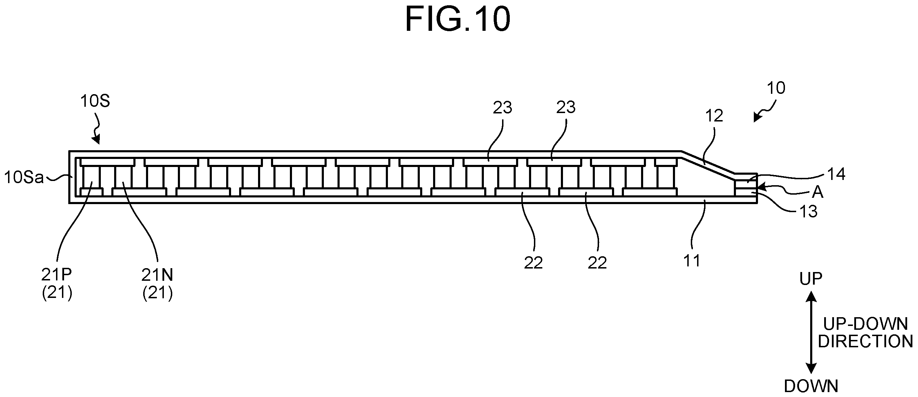

FIG. 10 is a cross-sectional view schematically illustrating a thermoelectric power generation module according to Modification 6 of the first embodiment. Modification 6 is different from the first embodiment in configurations of a first base material 11 and a second base material 12.

The first base material 11 and the second base material 12 are configured by bending one sheet-shaped base material 10S. In the modification, a lower side of a bent part 10Sa is assumed to be the first base material 11, and an upper side is assumed to be the second base material 12.

In Modification 6, a part where a metal film 13 and a metal film 14 are joined is referred to as a joint part A. The joint part A is disposed at a peripheral edge part of the base material 10S excluding the bent part 10Sa. In the rectangular base material 10S, three sides make the joint part A, and one side makes the bent part 10Sa.

In the embodiment, an area of the joint part A can be reduced. In the embodiment, a sealing property can be improved.

### (Modification 7)

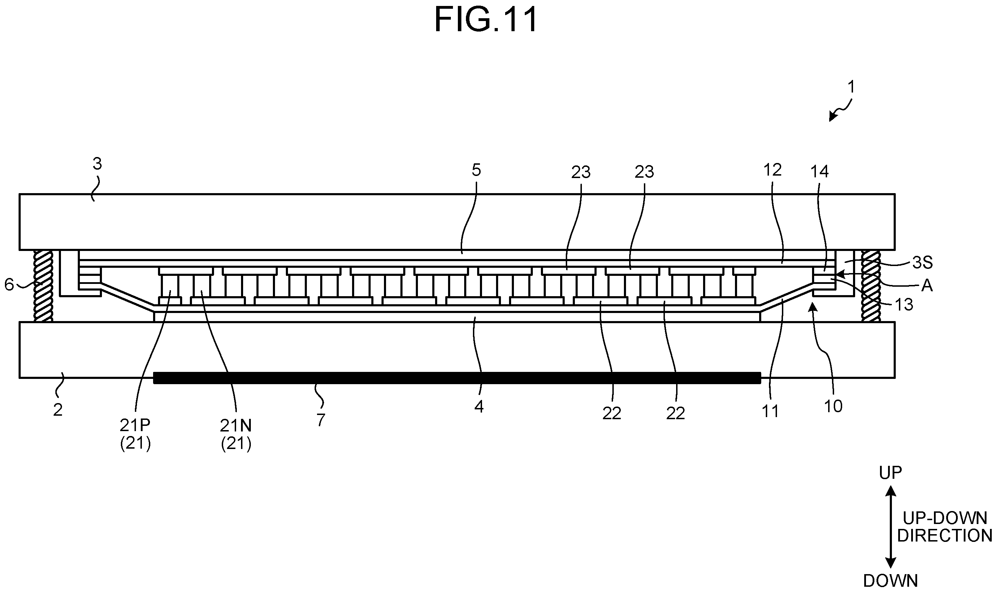

FIG. 11 is a cross-sectional view schematically illustrating a thermoelectric power generation unit according to Modification 7 of the first embodiment. Modification 7 is different from the first embodiment in that a support member 3S is provided. In Modification 7, **a** thermoelectric power generation module 10 is configured similarly to the first embodiment. In Modification 7, a joint part A is separated from a heat receiving plate 2 and is located on a cooling plate 3 side.

The support member 3S is disposed on a lower surface of the cooling plate 3. The support member 3S supports the joint part A on the cooling plate 3. For example, the support member 3S may support the joint part A by putting the joint part A inside a slit provided in the support member 3S, or may support the joint part A by bonding the joint part A to the support member 3S with an adhesive. A method of supporting the joint part A by the support member 3S is not limited.

According to the modification, it is possible to prevent the joint part A from lowering by its own weight. In the modification, a position of the joint part A in the up-down direction can be supported.

### [Modification 8]

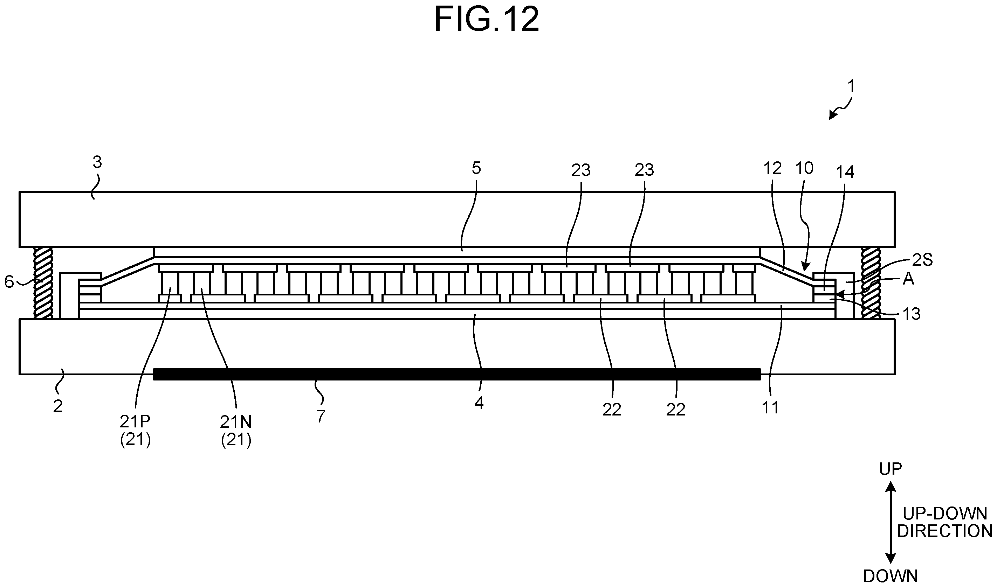

FIG. 12 is a cross-sectional view schematically illustrating a thermoelectric power generation unit according to Modification 8 of the first embodiment. Modification 8 is different from Modification 2 in that a support member 2S is provided. In Modification 8, **a** thermoelectric power generation module 10 is configured similarly to Modification **2.** In Modification 8, a joint part A is separated from a cooling plate 3 and is located on a heat receiving plate 2 side.

The support member 2S is disposed on an upper surface of the heat receiving plate 2. The support member 2S supports the joint part A on the heat receiving plate 2. For example, the support member 2S may support the joint part A by putting the joint part A inside a slit provided in the support member 2S, or may support the joint part A by bonding the joint part A to the support member 2S with an adhesive. A method of supporting the joint part A by the support member 2S is not limited.

According to the modification, the joint part A can be disposed away from the cooling plate 3. In the modification, heat leakage from the heat receiving plate 2 to the cooling plate 3 can be suppressed at the joint part A.

### [Modification 9]

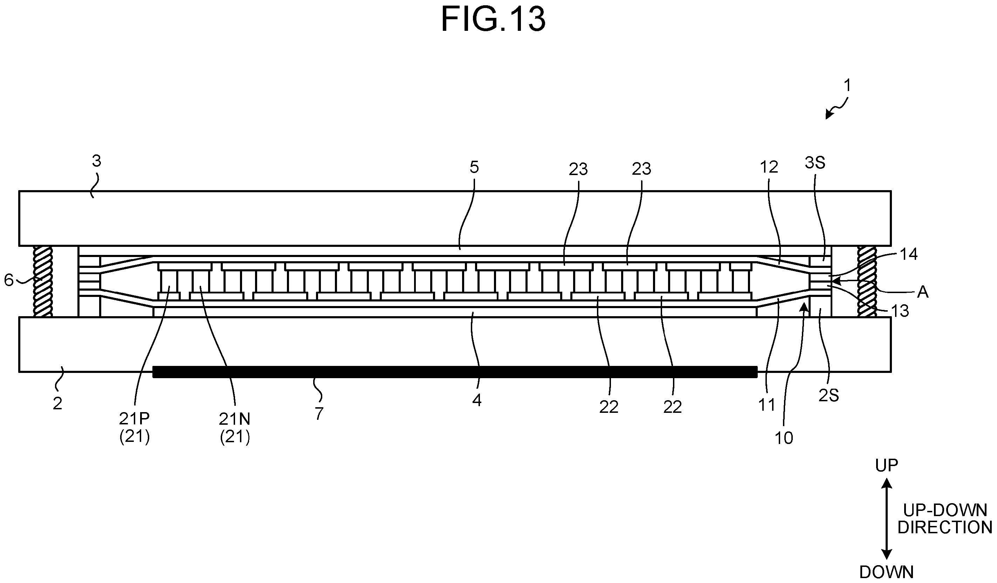

FIG. 13 is a cross-sectional view schematically illustrating a thermoelectric power generation unit according to Modification 9 of the first embodiment. Modification 9 is different from Modification 1 in that a support member 2S and a support member 3S are provided. In Modification 9, a thermoelectric power generation module 10 is configured similarly to Modification 1. A joint part A is located between a heat receiving plate 2 and a cooling plate 3 and is separated from the heat receiving plate 2 and the cooling plate 3.

The support member 2S is disposed on an upper surface of the heat receiving plate 2. The support member 3S is disposed on a lower surface of the cooling plate 3. The support member 2S sandwiches and supports the joint part A in the up-down direction together with the support member 3S. In other words, the support member 2S and the support member 3S support the joint part A between the heat receiving plate 2 and the cooling plate 3. A method of supporting the joint part A by the support member 2S and the support member 3S is not limited.

According to the modification, it is possible to prevent the joint part A from lowering by its own weight. In the modification, a position of the joint part A in the up-down direction can be supported.

### (Other Modifications of First Embodiment)

While the above Modification 7, Modification 8, and Modification 9 of the first embodiment have been described in a case where the joint part A is supported by at least one of the support member 2S and the support member 3S, the method of supporting the joint part A is not limited thereto. In the joint part A, at least one of the first base material 11 and the second base material 12 may be bonded to at least one of the heat receiving plate 2 and the cooling plate 3 by an adhesive.

While the above Modification 3, Modification 4, and Modification 5 of the first embodiment have been described with respect to the configuration in which at least one of the first base material 11 and the second base material 12 is folded back to form the joint part A, the folded shape of the first base material 11 and the second base material 12 is not limited thereto. For example, the first base material 11 may be folded back in a direction away from the second base material 12. The second base material 12 may be folded back in a direction away from the first base material 11.

A plurality of the above modifications of the first embodiment may be combined. For example, in Modification 6 illustrated in FIG. 10, the joint part A may have the shape of the first embodiment illustrated in FIG. 3, Modification 1 illustrated in FIG. 5, Modification 3 illustrated in FIG. 7, or Modification 5 illustrated in FIG. 9. For example, in Modification 8 of FIG. 12, the thermoelectric power generation module 10 may be the thermoelectric power generation module 10 of Modification 3 in FIG. 7 or the thermoelectric power generation module 10 of Modification 6 in FIG. 10.

### [Second Embodiment]

### [Thermoelectric Power Generation Unit]

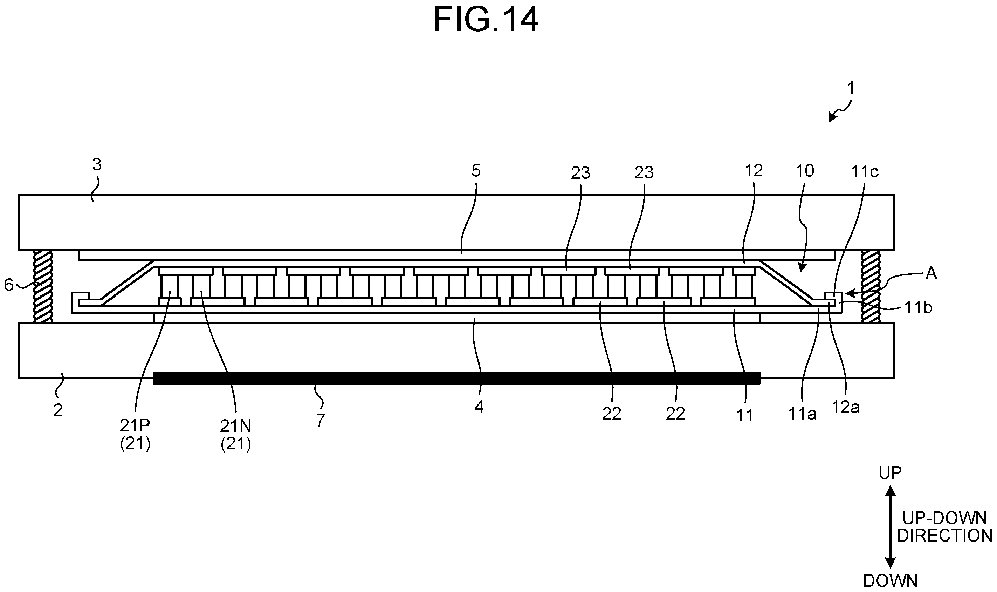

FIG. 14 is a cross-sectional view schematically illustrating a thermoelectric power generation unit according to a second embodiment. In a thermoelectric power generation unit 1, description of a configuration similar to that of the first embodiment is omitted. A thermoelectric power generation unit 1 includes a thermoelectric power generation module 10, a heat receiving plate 2 that is a high-temperature plate, a cooling plate 3 that is a low-temperature plate, a first heat transfer member 4, and a second heat transfer member 5.

### [Thermoelectric Power Generation Module]

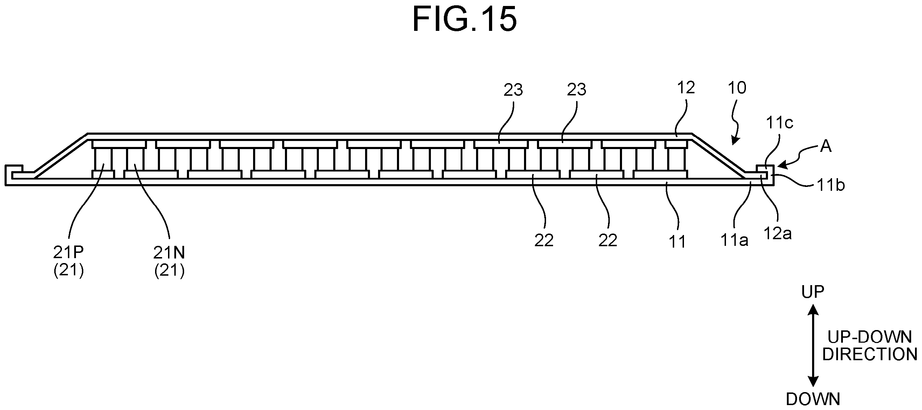

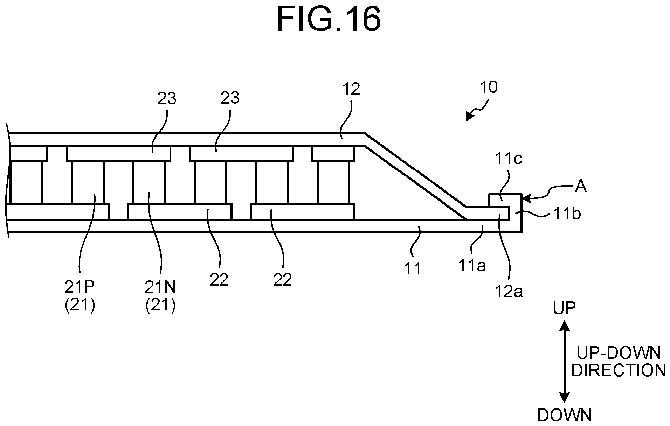

FIG. 15 is a cross-sectional view schematically illustrating the thermoelectric power generation module according to the second embodiment. FIG. 16 is a partially enlarged view of a joint part of the thermoelectric power generation module in FIG. 15. A plan view schematically illustrating a first base material of the thermoelectric power generation module according to the second embodiment is the same as FIG. 4 of the first embodiment.

A peripheral edge part of the first base material 11 is folded back at a bent part 11b. A distal end part 11a and a distal end part 11c of the first base material 11 are separated in the up-down direction. A distal end part 12a of a second base material 12 is sandwiched between the distal end part 11a and the distal end part 11c of the first base material 11. In other words, the distal end part 12a of the second base material 12 is sandwiched by the distal end part 11a, the bent part 11b, and the distal end part 11c of the first base material 11.

The second base material 12 has a peripheral edge part bent toward the first base material 11, in other words, bent so as to approach the first base material 11. The distal end part 12a of the second base material 12 is sandwiched by the distal end part 11a, the bent part 11b, and the distal end part 11c of the first base material 11.

A part where the distal end part 11a, the bent part 11b, and the distal end part 11c of the first base material 11 and the distal end part 1 of the second base material 12 are joined is referred to as a joint part A. In the joint part A, the distal end part 11a of the first base material 11, the distal end part 12a of the second base material 12, and the distal end part 11c of the first base material 11 are joined in an overlapping state from below in the up-down direction. The distal end part 11a of the first base material 11, the distal end part 12a of the second base material 12, and the distal end part 11c of the first base material 11 are joined with a resin adhesive.

A part where the first base material 11 and the second base material 12 are joined is referred to as a joint part A. The joint part A is disposed in a frame shape surrounding a periphery of a plurality of pn element pairs aligned in the plane direction as viewed in the up-down direction. The joint part A is disposed in the peripheral edge parts of the first base material 11 and the second base material 12. In the first base material 11 and the second base material 12 having rectangular shapes, four sides are the joint parts A.

In the embodiment, the joint part A is separated from the cooling plate 3 and is located on the heat receiving plate 2 side.

### [Sealing Method and Operation]

In a state where the first base material 11 and the second base material 12 are overlapped with each other, the joint part A which is the peripheral edge part of these materials is bonded with a resin adhesive. As a result, the first base material 11 and the second base material 12 are sealed at the joint part A which is the peripheral edge part.

### [Effects]

In the embodiment, by joining the first base material 11 and the second base material 12 in a state where at least one of them is bent, a joined area and a thickness of the joint part A are increased as compared with the joint part A in a state where the first base material 11 and the second base material 12 are joined without being bent. In the embodiment, since a sealing frame of a different kind of material is not used, thermal deformation, warpage, and the like due to a difference in thermal expansion coefficient are less likely to occur, and durability can be easily maintained. According to the embodiment, it is possible to reduce a possibility of deterioration of a sealing property and a possibility of disconnection of the thermoelectric power generation module 10.

In the embodiment, as compared with a central part of the thermoelectric power generation module 10 in which the thermoelectric conversion elements 21 are disposed, the joint part A that is a sealed part of an outer peripheral part of the thermoelectric power generation module 10 has a smaller thickness in the up-down direction, and a gap is generated between the joint part A and the cooling plate **3.** According to the embodiment, the joint part A can be disposed away from the cooling plate **3.** Therefore, in the embodiment, heat leakage from the heat receiving plate 2 to the cooling plate 3 can be suppressed at the joint part **A.** According to the embodiment, a possibility of reduction in power generation output of the thermoelectric power generation module 10 can be reduced.

In the embodiment, the first base material 11 and the second base material 12 can be bonded with a resin adhesive without using a sealing member such as a sealing material and a frame member made of an adhesive or a resin material. In the embodiment, deterioration of a sealing member due to aging does not occur. According to the embodiment, the sealing property can be maintained for a long period of time under an environment exposed to wind and rain, a high humidity and high temperature environment, and dust. As described above, in the embodiment, since neither an adhesive nor a resin material having a low heat-resistant is used, heat resistance and temperature resistance cyclicity can be improved.

In the embodiment, it is possible to restrict water and dust which cause a short circuit from entering the inside of the thermoelectric power generation module 10 over a long period of time under an environment exposed to wind and rain, a high humidity and high temperature environment, and dust. In the embodiment, thermoelectric power generation can be performed while insulation is maintained for a long period of time under a high-temperature environment. In this way, according to the embodiment, it is possible to suppress the occurrence of a failure due to intrusion of moisture and to stably generate power.

As described above, according to the embodiment, it is possible to suppress a decrease in sealing property, to reduce a possibility of disconnection, and to suppress a decrease in power generation output.

In the embodiment, for example, when the thermoelectric power generation module 10 is manufactured by integral reflow molding, flux tends to remain. According to the embodiment, since steam is easily removed by the remaining flux, bulging of an electrode surface can be suppressed.

In the embodiment, a joined area and a thickness of the joint part A can be increased as compared with a state in which the first base material 11 and the second base material 12 are joined without being bent. As a result, in the embodiment, due to the thickness of the joint part A, warpage can be suppressed even in a case of a one-side heater.

Modifications 1 to 7 of the second embodiment will be described below.

### (Modification 1)

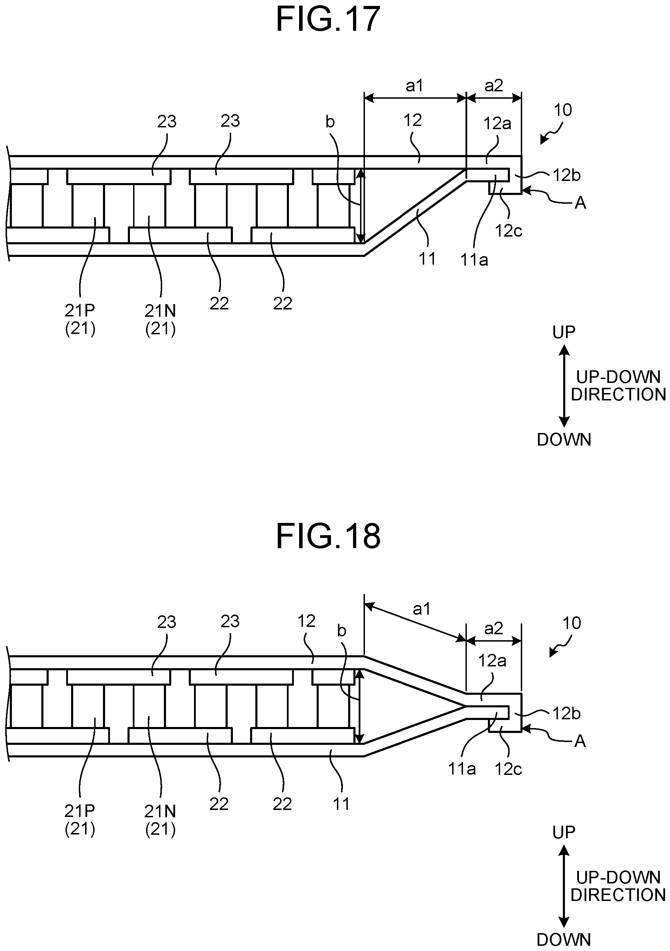

FIG. 17 is a partially enlarged view of a joint part of a thermoelectric power generation module according to Modification 1 of the second embodiment. Modification 1 is different from the second embodiment in a configuration of a joint part A.

In Modification 1, the joint part A is separated from a heat receiving plate 2 and located on a cooling plate 3 side.

A first base material 11 has a peripheral edge part bent toward a second base material 12, in other words, bent so as to approach the second base material 12. A distal end part 11a of the first base material 11 is sandwiched by a distal end part 12a, a bent part 12b, and a distal end part 12c of the second base material 12.

A peripheral edge part of the second base material 12 is folded back at the bent part 12b. The distal end part 12a and the distal end part 12c of the second base material 12 are separated in the up-down direction. The distal end part 11a of the first base material 11 is sandwiched between the distal end part 12a and the distal end part 12c of the second base material 12. In other words, the distal end part 11a of the first base material 11 is sandwiched by the distal end part 21a, the bent part 21b, and the distal end part 21c of the second base material 21.

A part where the distal end part 12a, the bent part 12b, and the distal end part 12c of the second base material 12 and the distal end part 11a of the first base material 11 are joined is referred to as a joint part A. In the joint part A, the distal end part 12c of the second base material 12, the distal end part 11a of the first base material 11, and the distal end part 12a of the second base material 12 are joined in an overlapping state from below in the up-down direction. The distal end part 12a of the second base material 12, the distal end part 11a of the first base material 11, and the distal end part 12c of the second base material 12 are bonded with a resin adhesive.

The joint part A is disposed in the peripheral edge parts of the first base material 11 and the second base material 12. In the first base material 11 and the second base material 12 having rectangular shapes, four sides are the joint parts A.

A dimension of a peripheral edge part of the thermoelectric power generation module 10, specifically, dimensions of the joint part A and a peripheral part thereof may be as follows. A length from an outer edge part of a plurality of first electrodes 22 and a plurality of second electrodes 23 disposed between the first base material 11 and the second base material 12 to the joint part A is defined as a1. A length of the joint part A is defined as a2. A length between the upper surface side of the first base material 11 and the lower surface side of the second base material 12 is defined as b. At this time, a1, a2, and b may be set such that a1+a2>b holds.

According to the modification, the joint part A can be disposed away from the heat receiving plate 2. In the modification, heat leakage from the heat receiving plate 2 to the cooling plate 3 can be suppressed at the joint part A.

In the modification, a1, a2, and b are set such that a1+a2>b holds, where a1 is the length from the outer edge part of the first electrodes 22 and the second electrodes 23 to the joint part A, a2 is the length of the joint part A, and b is the length between the upper surface side of the first base material 11 and the lower surface side of the second base material 12. According to the modification, it is possible to prevent the joint part A from lowering by its own weight and coming into contact with the first base material 11.

### (Modification 2)

FIG. 18 is a partially enlarged view of a joint part of a thermoelectric power generation module according to Modification 1 of the second embodiment. Modification 2 is different from the second embodiment in a configuration of a joint part A.

In Modification 2, the joint part A is separated from a heat receiving plate 2 and a cooling plate 3. In other words, the joint part A is located at an intermediate part between the heat receiving plate 2 and the cooling plate 3 in the up-down direction (thickness direction).

A first base material 11 has a peripheral edge part bent toward a second base material 12, in other words, bent so as to approach the second base material 12. A distal end part 11a of the first base material 11 is sandwiched by a distal end part 12a, a bent part 12b, and a distal end part 12c of the second base material 12.

The second base material 12 has a peripheral edge part bent toward the first base material 11, in other words, bent so as to approach the first base material 11. The peripheral edge part of the first base material 11 and the peripheral edge part of the second base material 12 are formed so as to approach each other.

A peripheral edge part of the second base material 12 is folded back at the bent part 12b. The distal end part 12a and the distal end part 12c of the second base material 12 are separated in the up-down direction. The distal end part 11a of the first base material 11 is sandwiched between the distal end part 12a and the distal end part 12c of the second base material 12. In other words, the distal end part 11a of the first base material 11 is sandwiched by the distal end part 21a, the bent part 21b, and the distal end part 21c of the second base material 21.

A part where the distal end part 12a, the bent part 12b, and the distal end part 12c of the second base material 12 and the distal end part 11a of the first base material 11 are joined is referred to as a joint part A. In the joint part A, the distal end part 12c of the second base material 12, the distal end part 11a of the first base material 11, and the distal end part 12a of the second base material 12 are joined in an overlapping state from below in the up-down direction. The distal end part 12a of the second base material 12, the distal end part 11a of the first base material 11, and the distal end part 12c of the second base material 12 are bonded with a resin adhesive.

The joint part A is disposed in the peripheral edge parts of the first base material 11 and the second base material 12. In the first base material 11 and the second base material 12 having rectangular shapes, four sides are the joint parts A.

A length from an outer edge part of a plurality of first electrodes 22 and a plurality of second electrodes 23 disposed between the first base material 11 and the second base material 12 to the joint part A is defined as a1. A length of the joint part A is defined as a2. A length between the upper surface side of the first base material 11 and the lower surface side of the second base material 12 is defined as b. At this time, a1, a2, and b may be set such that a1+a2>b holds.

According to the modification, the joint part A can be disposed away from the heat receiving plate 2 and the cooling plate 3. In the modification, heat leakage from the heat receiving plate 2 to the cooling plate 3 can be suppressed at the joint part A.

In the modification, a1, a2, and b are set such that a1+a2>b holds, where a1 is the length from the outer edge part of the first electrodes 22 and the second electrodes 23 to the joint part A, a2 is the length of the joint part A, and b is the length between the upper surface side of the first base material 11 and the lower surface side of the second base material 12. According to the modification, it is possible to prevent the joint part A from lowering by its own weight and coming into contact with the first base material 11.

### (Modification 3)

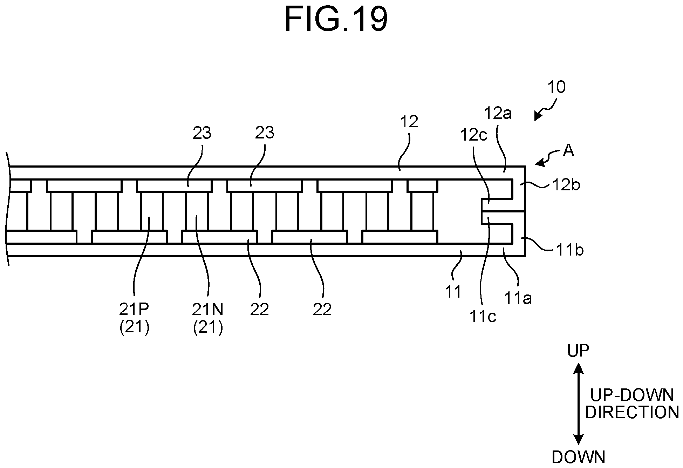

FIG. 19 is a partially enlarged view of a joint part of a thermoelectric power generation module according to Modification 3 of the second embodiment. Modification 3 is different from the second embodiment in a configuration of a joint part A.

A peripheral edge part of the first base material 11 is folded back at a bent part 11b. A distal end part 11a and a distal end part 11c of the first base material 11 are separated in the up-down direction. The distal end part 11c of the first base material 11 is joined to a distal end part 12c of a second base material 12.

A peripheral edge part of the second base material 12 is folded back at the bent part 12b. The distal end part 12a and the distal end part 12c of the second base material 12 are separated in the up-down direction. The distal end part 12c of the second base material 12 is joined to the distal end part 11c of the first base material 11.

In the joint part A, the distal end part 11a of the first base material 11, the distal end part 11c of the first base material 11, the distal end part 12c of the second base material 12, and the distal end part 12a of the second base material 12 are aligned from below in the up-down direction. The distal end part 11c of the first base material 11 and the distal end part 12c of the second base material 12 are joined with a resin adhesive.

According to the modification, a joined area and a thickness of the joint part A can be increased as compared with a state in which the first base material 11 and the second base material 12 are joined without being bent.

### (Modification 4)

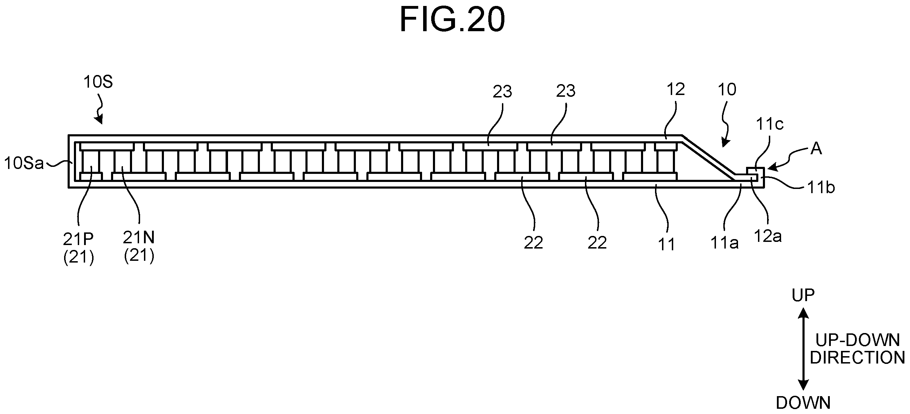

FIG. 20 is a cross-sectional view schematically illustrating a thermoelectric power generation module according to Modification 4 of the second embodiment. Modification 4 is different from the second embodiment in a configuration of a joint part A.

The first base material 11 and the second base material 12 are configured by bending one sheet-shaped base material 10S. In the modification, a lower side of a bent part 10Sa is assumed to be the first base material 11, and an upper side is assumed to be the second base material 12.

The joint part A is disposed at a peripheral edge part of the base material 10S excluding the bent part 10Sa. In the rectangular base material 10S, three sides make the joint part A, and one side makes the bent part 10Sa.

In the embodiment, an area of the joint part A can be reduced. In the embodiment, a sealing property can be improved.

### (Modification 5)

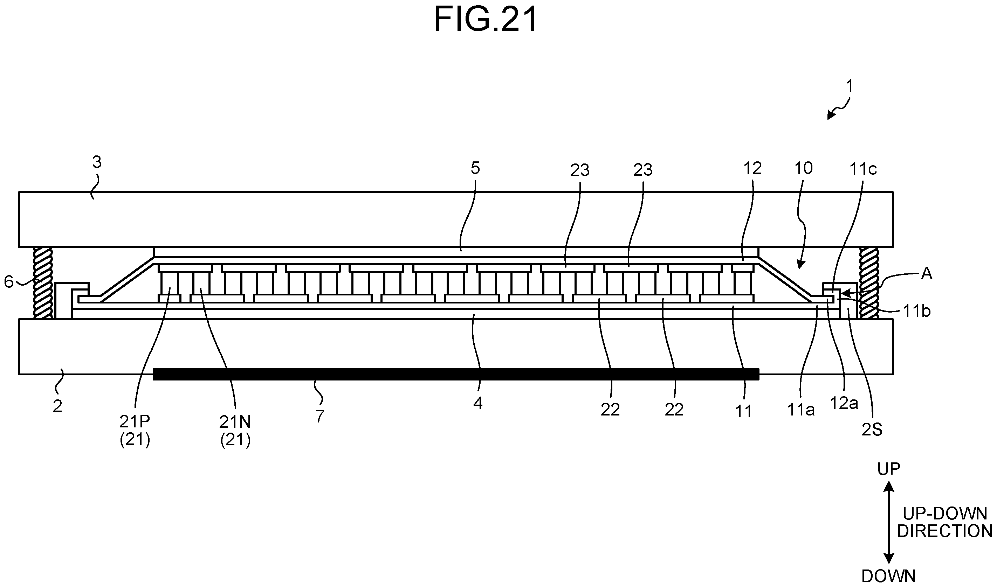

FIG. 21 is a cross-sectional view schematically illustrating a thermoelectric power generation unit according to Modification 5 of the second embodiment. Modification 5 is different from the second embodiment in that a support member 2S is provided. In Modification 5, a thermoelectric power generation module 10 is configured similarly to the second embodiment. In Modification 5, a joint part A is separated from a cooling plate 3 and is located on a heat receiving plate 2 side.

The support member 2S is disposed on an upper surface of the heat receiving plate 2. The support member 2S supports the joint part A on the heat receiving plate 2. For example, the support member 2S may support the joint part A by putting the joint part A inside a slit provided in the support member 2S, or may support the joint part A by bonding the joint part A to the support member 2S with an adhesive. A method of supporting the joint part A by the support member 2S is not limited.

According to the modification, the joint part A can be disposed away from the cooling plate **3.** In the modification, heat leakage from the heat receiving plate 2 to the cooling plate 3 can be suppressed at the joint part **A.**

### (Modification 6)

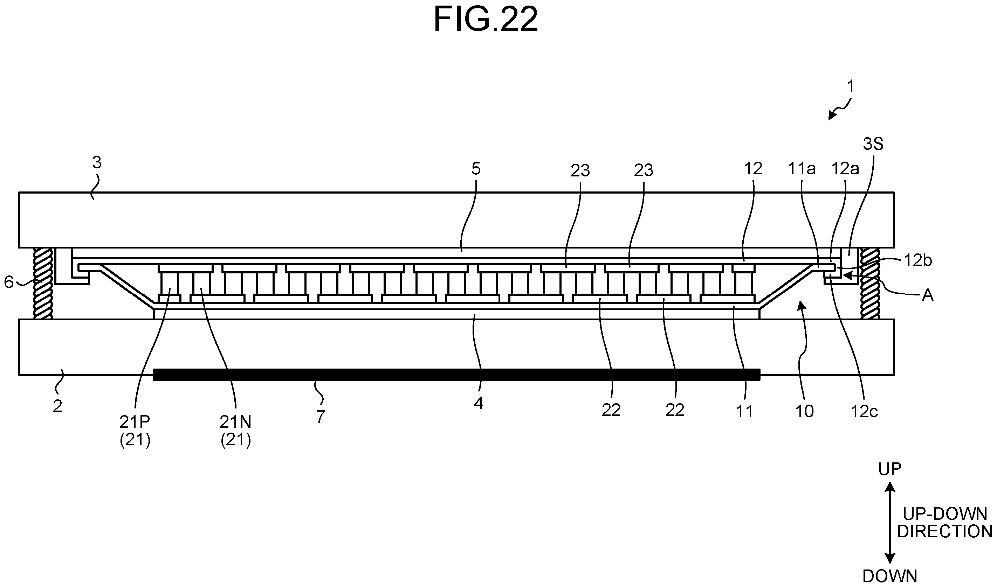

FIG. 22 is a cross-sectional view schematically illustrating a thermoelectric power generation unit according to Modification 6 of the second embodiment. Modification 6 is different from Modification 1 of the second embodiment in that a support member 3S is provided. In Modification 6, a thermoelectric power generation module 10 is configured similarly to Modification 2. In Modification 6, a joint part A is separated from a heat receiving plate 2 and is located on a cooling plate 3 side.

The support member 3S is disposed on a lower surface of the cooling plate 3. The support member 3S supports the joint part A on the cooling plate 3. For example, the support member 3S may support the joint part A by putting the joint part A inside a slit provided in the support member 3S, or may support the joint part A by bonding the joint part A to the support member 3S with an adhesive. A method of supporting the joint part A by the support member 3S is not limited.

According to the modification, it is possible to prevent the joint part A from lowering by its own weight. In the modification, a position of the joint part A in the up-down direction can be supported.

### (Modification 7)

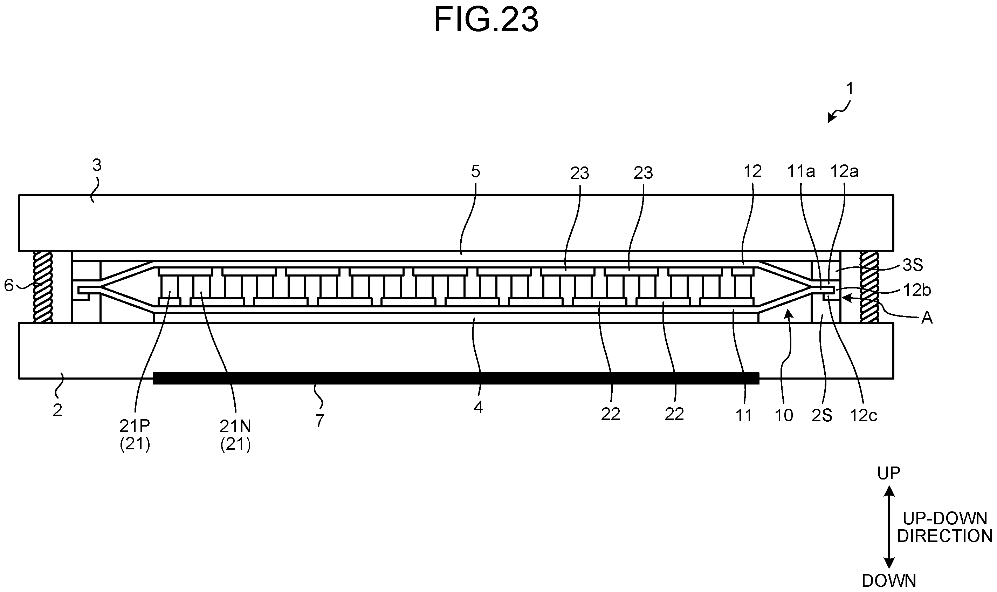

FIG. 23 is a cross-sectional view schematically illustrating a thermoelectric power generation unit according to Modification 7 of the second embodiment. Modification 7 is different from Modification 2 of the second embodiment in that a support member 2S and a support member 3S are provided. In Modification 7, a thermoelectric power generation module 10 is configured similarly to Modification 2. A joint part A is located between a heat receiving plate 2 and a cooling plate 3 and is separated from the heat receiving plate 2 and the cooling plate 3.

The support member 2S is disposed on an upper surface of the heat receiving plate 2. The support member 3S is disposed on a lower surface of the cooling plate 3. The support member 2S sandwiches and supports the joint part A in the up-down direction together with the support member 3S. In other words, the support member 2S and the support member 3S support the joint part A between the heat receiving plate 2 and the cooling plate 3. A method of supporting the joint part A by the support member 2S and the support member 3S is not limited.

According to the modification, it is possible to prevent the joint part A from lowering by its own weight. In the modification, a position of the joint part A in the up-down direction can be supported.

### (Other Modifications of Second Embodiment)

While the above Modification 5, Modification 6, and Modification 7 of the second embodiment have been described in a case where the joint part A is supported by at least one of the support member 2S and the support member 3S, the method of supporting the joint part A is not limited thereto. In the joint part A, at least one of the first base material 11 and the second base material 12 may be bonded to at least one of the heat receiving plate 2 and the cooling plate 3 by an adhesive.

While the above modifications of the second embodiment have been described with respect to the configuration in which at least one of the first base material 11 and the second base material 12 is folded back to form the joint part A, the folded shape of the first base material 11 and the second base material 12 is not limited thereto. For example, the first base material 11 may be folded back in a direction away from the second base material 12. The second base material 12 may be folded back in a direction away from the first base material 11.

### Reference Signs List

- 1: THERMOELECTRIC POWER GENERATION UNIT

- 2: HEAT RECEIVING PLATE
- 3: COOLING PLATE
- 4: FIRST HEAT TRANSFER MEMBER
- 5: SECOND HEAT TRANSFER MEMBER
- 6: FASTENING MEMBER
- 7: SURFACE TREATED PART
- 10: THERMOELECTRIC POWER GENERATION MODULE
- 11: FIRST BASE MATERIAL
- 12: SECOND BASE MATERIAL
- 13: METAL FILM
- 14: METAL FILM
- 21: THERMOELECTRIC CONVERSION ELEMENT
- 21P: p-TYPE ELEMENT
- 21N: n-TYPE ELEMENT
- 22: FIRST ELECTRODE
- 23: SECOND ELECTRODE
- A: JOINT PART

## Claims

1. A thermoelectric power generation module comprising:
a first base material formed in a sheet shape;
a second base material formed in a sheet shape;
a plurality of thermoelectric conversion elements disposed between the first base material and the second base material;
a plurality of first electrodes disposed between the first base material and the thermoelectric conversion elements;
a plurality of second electrodes disposed between the second base material and the thermoelectric conversion elements; and
a joint part that joins the first base material and the second base material,
wherein
the thermoelectric conversion elements, the plurality of first electrodes, and the plurality of second electrodes are sealed by a joint part, and
the joint part bonds the first base material and the second base material with a metal film interposed therebetween by soldering.

2. A thermoelectric power generation module comprising:
a first base material formed in a sheet shape;
a second base material formed in a sheet shape;
a plurality of thermoelectric conversion elements disposed between the first base material and the second base material;
a plurality of first electrodes disposed between the first base material and the thermoelectric conversion elements;
a plurality of second electrodes disposed between the second base material and the thermoelectric conversion elements; and
a joint part that joins the first base material and the second base material,
wherein
the thermoelectric conversion elements, the plurality of first electrodes, and the plurality of second electrodes are sealed by a joint part, and
the joint part joins the first base material and the second base material in a state where at least one of the first and second base materials is bent.

3. The thermoelectric power generation module according to claim 1 or 2, wherein
a1+a2>b holds when a length from an outer edge part of the plurality of first electrodes and the second electrodes disposed between the first base material and the second base material to the joint part is defined as a1, a length of the joint part is defined as a2, and a length between an upper surface side of the first base material and a lower surface side of the second base material is defined as **b.**

4. A thermoelectric power generation unit comprising:
the thermoelectric power generation module according to claim 1;
a heat receiving plate disposed on the first base material side of the thermoelectric power generation module;
a first heat transfer member interposed between the thermoelectric power generation module and the heat receiving plate;
a cooling plate disposed on the second base material side of the thermoelectric power generation module; and
a second heat transfer member interposed between the thermoelectric power generation module and the cooling plate.

5. A thermoelectric power generation unit comprising:
the thermoelectric power generation module according to claim 2;
a heat receiving plate disposed on the first base material side of the thermoelectric power generation module;
a first heat transfer member interposed between the thermoelectric power generation module and the heat receiving plate;
a cooling plate disposed on the second base material side of the thermoelectric power generation module; and
a second heat transfer member interposed between the thermoelectric power generation module and the cooling plate.

6. The thermoelectric power generation unit according to claim 4 or 5, wherein
the joint part is located between the heat receiving plate and the cooling plate and is separated from the heat receiving plate and the cooling plate.

7. The thermoelectric power generation unit according to claim 4 or 5, further comprising
a support member that supports the joint part between the heat receiving plate and the cooling plate.

8. The thermoelectric power generation unit according to claim 4 or 5, wherein
the joint part is separated from the heat receiving plate.

9. The thermoelectric power generation unit according to claim 4 or 5, further comprising
a support member that supports the joint part on the cooling plate.

10. The thermoelectric power generation unit according to claim 4 or 5, wherein
the joint part is separated from the cooling plate.

11. The thermoelectric power generation unit according to claim 4 or 5, further comprising
a support member that supports the joint part on the heat receiving plate.
